# EUROPEAN PATENT SPECIFICATION

(11) **EP 1 981 279 B1**
(45) Date of publication and mention of the grant of the patent: **21.11.2018**
(21) Application number: 07106194.9
(22) Date of filing: 13.04.2007
(51) Int. Cl.: G06F 9/44, H03M 7/40, H04N 19/91, H04N 19/42

(54) **Decoding entropy-encoded data using dynamic program generation**
Dekodierung entropiekodierter Daten mittels dynamischer Programmgenerierung
Décodeur des données codées par entropie utilisant la génération automatique de programmes

(43) Date of publication of application: 15.10.2008
(73) Proprietor: BlackBerry Limited, Waterloo, ON N2K 0A7 (CA)
(72) Inventor: Lamb, Brian, Waterloo Ontario N2V 2K9 (CA); Carmody, Michael James, Waterloo Ontario N2L 3T7 (CA); Wu, Guixing, Waterloo Ontario N2L 3Y1 (CA)
(74) Representative: Gill Jennings & Every LLP

(56) References cited:
- EP-A- 1 610 220
- KAMIN S: "Program Generation Considered Easy" PROCEEDINGS OF THE 2004 ACM SIGPLAN SYMPOSIUM ON PARTIAL EVALUATION AND SEMANTICS-BASED PROGRAM MANIPULATION (PEPM '04), 24 August 2004 (2004-08-24), pages 68-79, XP002454768 ACM Press
- CHUANG Y-J ET AL: "An SGH-Tree Based Efficient Huffman Decoding" PROCEEDINGS OF THE 2003 JOINT CONFERENCE ON INFORMATION, COMMUNICATIONS AND SIGNAL PROCESSING AND THE FOURTH PACIFIC RIM CONFERENCE ON MULTIMEDIA, vol. 3, 15 December 2003 (2003-12-15), pages 1483-1487, XP010701606 IEEE, Piscataway, NJ, US ISBN: 0-7803-8185-8
- CHANG Y-W ET AL: "Direct mapping architecture for JPEG Huffman decoder" IEE PROCEEDINGS ON COMMUNICATIONS, vol. 153, no. 3, 2 June 2006 (2006-06-02), pages 333-340, XP006026661 Institution of Electrical Engineers, GB ISSN: 1350-2425
- ENGLER D R: "VCODE: A Retargetable, Extensible, Very Fast Dynamic Code Generation System" ACM SIGPLAN NOTICES, vol. 31, no. 5, 21 May 1996 (1996-05-21), pages 160-170, XP001159779 ACM, New York, NY, US ISSN: 0362-1340
- LATENDRESSE M ET AL: "Generation of fast interpreters for Huffman compressed bytecode", SCIENCE OF COMPUTER PROGRAMMING, ELSEVIER BV, NL, vol. 57, no. 3, 1 September 2005 (2005-09-01), pages 295-317, XP027745969, ISSN: 0167-6423 [retrieved on 2005-09-01]

## Description

The invention described herein relates to a method of decoding an entropy-encoded data stream. In particular, the invention relates to a computer-based method of decompressing an electronic image that comprises compressed image data and an associated Huffman table.

JPEG (Joint Photographic Experts Group) is a commonly-used method for compressing and decompressing photographic images. The method typically involves downsampling the Y, Cb and Cr chroma components of the image, transforming the chroma components to the frequency domain, quantizing and then entropy-coding the result. Typically, the image is entropy-coded by run-length encoding the frequency domain components, and then Huffman-encoding the result. The JPEG standard allows for the use of general-purpose Huffman tables, or custom Huffman tables that have been optimized for the frequency-domain characteristics of the image.

JFIF (JPEG File Interchange Format) is the standardized image format for transmitting JPEG images across the Internet. According to this standard, the file header includes the Huffman table that was used to encode the image. Therefore, to decompress the image at its destination, the recipient device must first extract the Huffman table from the JPEG file, and then decode the image components using the extracted Huffman tree. This procedure typically requires multiple main memory accesses to the Huffman tree until the image is completely decoded. As a result, decoding a JPEG file can be computationally expensive, resulting in poor performance on MIPS-constrained devices, such as handheld communications devices.

S. Kamin ("Program Generation Considered Easy", XP002454768, ACM Press), describes a Java compiler that can dynamically generate high level Java program code at run-time to decode a Huffman-encoded string. Although the Java code can implement a Huffman tree, the solution is impractical for MIPS-constrained devices.

In "Generation of Fast Interpreters for Huffman Compressed Bytecode", Science of Computer programming, vol. 57, no. 3 (2005), M. Latendresse and M. Feeley disclose the use of canonical Huffman codes to generate compact opcodes with custom-sized operand fields. A virtual machine that directly executes this compact code. This document discloses techniques to automatically generate new instruction formats and a decoder. In effect, this automatically creates both an instruction set for a customized virtual machine and an implementation of that machine.

### GENERAL

According to the invention described herein, a handheld communications device may include a JIT (Just In Time) compiler that is configured to construct a binary tree of prefix codes as native machine code from a set of prefix codes.

In accordance with a first aspect of the invention, there may be provided a method of decoding a data stream that is encoded with a set of prefix codes. The method, according to this first aspect of the invention, begins by receiving the data stream at a computing device, and then writing native machine code for execution by a processing unit of the computing device. The native machine code provides an implementation of a binary tree of prefix codes that corresponds to the prefix code set. The implementation of the binary prefix code tree includes shift opcodes and branch opcodes, and excludes memory access opcodes and loop opcodes.

The data stream may be decoded by traversing the prefix code tree. The traversing step involves executing the machine code at the computing device in response to the encoded data.

In accordance with a second aspect of the invention, there may be provided a method of decompressing an electronic image. The electronic image comprises compressed image data, and a set of prefix codes that is associated with the compressed image data.

The method, according to this second aspect of the invention, may begin by receiving the compressed electronic image at a handheld computing device, and then writing native machine code, at the handheld computing device, for execution by the handheld computing device. The native machine code provides an implementation of a binary tree of prefix codes that corresponds to the prefix code set. The implementation of the binary prefix code tree includes shift opcodes and branch opcodes, and excludes memory access opcodes and loop opcodes.

The compressed image data may be decompressed by traversing the prefix code tree. The traversing step comprises executing the machine code at the handheld computing device in response to the compressed image data.

In accordance with a third aspect of the invention, there may be provided a communications device that is configured to decompress an electronic image that comprises compressed image data and an associated set of prefix codes. The prefix code set is associated with the compressed electronic image, and facilitates decoding of the compressed image data.

The communications device may comprise a data receiver, and a processing unit that is coupled to the data receiver. The data receiver is configured to receive the compressed electronic image.

The processing unit is configured to write native machine code that is configured for execution by the processing unit.

The native machine code provides an implementation of a binary tree of prefix codes that corresponds to the prefix code set. The implementation of the binary prefix code tree includes shift opcodes and branch opcodes, and excludes memory access opcodes and loop opcodes.

The machine code also implements an image de-compressor that is configured to decompress the compressed image data. The image de-compressor is configured to traverse the prefix code tree by executing the machine code in response to the compressed image data.

In accordance with a fourth aspect of the invention, there may be provided a computer readable medium that carries processing instructions for an electronic communications device. The processing instructions, when executed by a computer processor of the communications device, may enable the device to decode a data stream that is encoded with a set of prefix codes.

The method of decoding the data stream, according to this fourth aspect of the invention, may begin by receiving the data stream at the communications device, and then writing native machine code for execution by a processing unit of the communications device. The native machine code provides an implementation of a binary tree of prefix codes that corresponds to the prefix code set. The implementation of the binary prefix code tree includes shift opcodes and branch opcodes, and excludes memory access opcodes and loop opcodes.

The data stream may be decoded by traversing the prefix code tree. The traversing step may involve executing the machine code with the processing unit in response to the data stream.

In a preferred implementation, the prefix code set may comprise a Huffman table, and the prefix code tree comprises a Huffman tree. The handheld computing device may comprise a processing unit, and a main memory coupled to the processing unit, and the image de-compressor traverses the Huffman tree by executing the machine code at the processing unit without accessing the main memory. Further, the implementation of the binary prefix code tree may consist register shift opcodes, register load opcodes, branch opcodes and/or return opcodes.

Preferably, one of the branch opcodes comprises a bit test opcode, and the processing unit traverses the nodes of the Huffman tree by executing one of the bit test opcodes in association with a processor data register that maintains a portion of the compressed image data. Further, preferably the processing unit traverses one branch of the node by executing one of the shift opcodes in response to one outcome of the bit test opcode, and traverses another branch of the node by branching to another of the bit test opcodes in response to another outcome of the bit test opcode. Preferably, the processing unit also executes one of the return opcodes in response to one outcome of the bit test opcode, with the processing unit returning decompressed image data upon execution of the return opcode.

### BRIEF DESCRIPTION OF THE DRAWINGS

The invention will now be described, by way of example only, with reference to the accompanying drawings, in which:
Fig. 1 is a front plan view of a handheld communications device according to the invention;
Fig. 2 is a schematic diagram depicting certain functional details of the data processing means of the handheld communications device, including the JIT compiler; Fig. 3 is a schematic diagram depicting certain additional functional details of the handheld communications device;
Fig. 4 is a flow chart depicting, by way of overview, the method performed by the handheld communications device when decoding a data stream that is encoded with a set of prefix codes;
Fig. 5 (comprising Figs. 5a to 5b) is a flow chart depicting, in detail, the method performed by the handheld communications device when decompressing an electronic image that comprises compressed image data, and a Huffman table;
Fig. 6 is a sample Huffman tree depicting Huffman table data;
Fig. 7 is a flowchart that depicts one algorithm which the JIT compiler may use to dynamically generate native machine code which defines an image de-compressor;
Fig. 8 is a flowchart that depicts a preferred algorithm which the JIT compiler uses to dynamically generate the native machine code, without constructing a Huffman tree; and
Fig. 9 is data flow diagram depicting the encoded data stream that is transferred to the image de-compressor, and the decoded data stream that is received from the image de-compressor.

### DESCRIPTION OF PREFERRED EMBODIMENTS

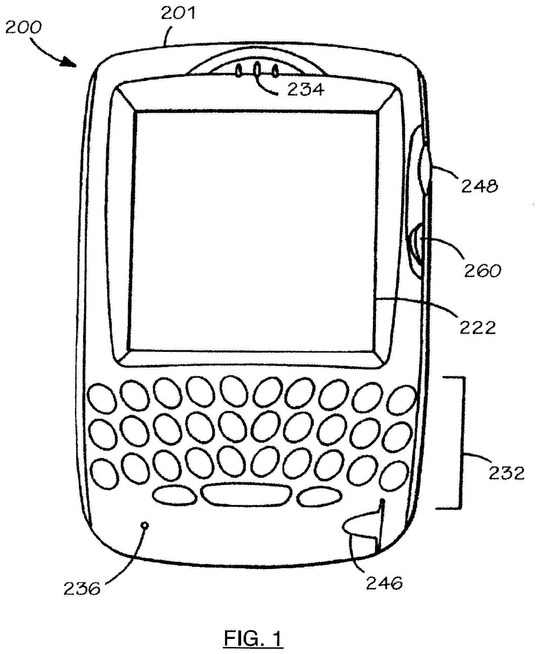

Turning to Fig. 1, there is shown a sample handheld communications device 200 in accordance with the invention. Preferably, the handheld communications device 200 is a two-way wireless communications device having at least voice and data communication capabilities, and is configured to operate within a wireless cellular network. Depending on the exact functionality provided, the wireless handheld communications device 200 may be referred to as a data messaging device, a two-way pager, a wireless e-mail device, a cellular telephone with data messaging capabilities, a wireless Internet appliance, or a data communication device, as examples.

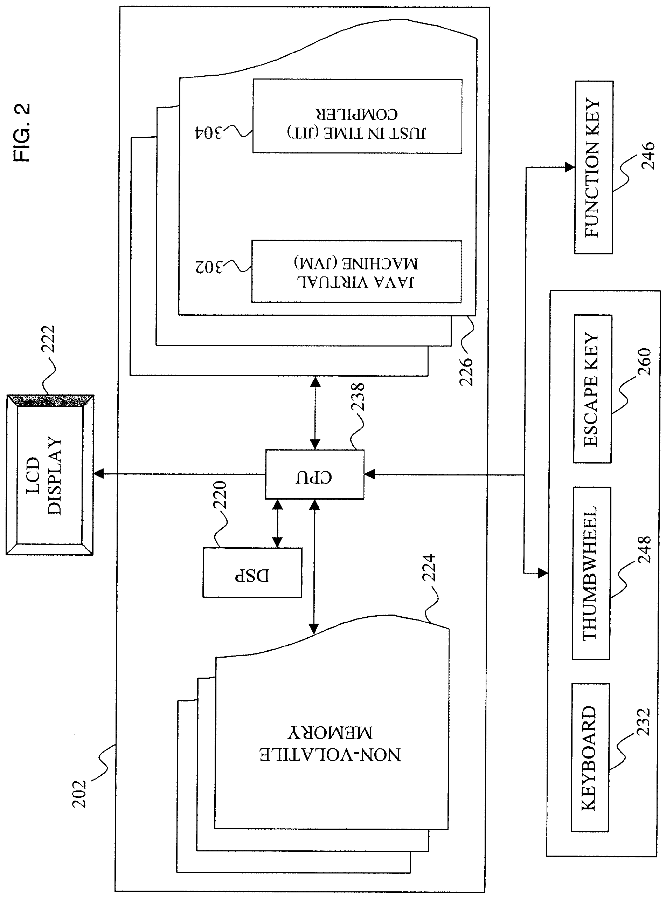

As shown, the handheld communications device 200 includes a display 222, a function key 246, and data processing means 202 (see Fig. 2) disposed within a common housing 201. The display 222 comprises a backlit LCD display. The data processing means 202 is in communication with the display 222 and the function key 246. In one implementation, the backlit display 222 comprises a transmissive LCD display, and the function key 246 operates as a power on/off switch. Alternately, in another implementation, the backlit display 222 comprises a reflective or trans-reflective LCD display, and the function key 246 operates as a backlight switch.

In addition to the display 222 and the function key 246, the handheld communications device 200 includes user data input means for inputting data to the data processing means. As shown, preferably the user data input means includes a keyboard 232, a thumbwheel 248 and an escape key 260. The keyboard 232 includes alphabetic and numerical keys, and preferably also includes a "Send" key and an "End" key to respectively initiate and terminate voice communication. However, the data input means is not limited to these forms of data input. For instance, the data input means may include a trackball or other pointing device instead of (or in addition to) the thumbwheel 248.

As shown in Fig. 2, the data processing means 202 comprises a microprocessor 238 in communication with flash memory 224 and volatile memory (RAM) 226. The flash memory 224 includes computer processing instructions which, when executed by the microprocessor 238, implement an operating system, computer programs, and operating system specific applications. Alternately, the computer processing instructions may be copied from the flash memory 224 into the RAM 226 upon system reset or power-up, and executed by the microprocessor 238 out of the RAM 226. The operating system comprises an Open Systems Interconnection (OSI) communication protocol stack that allows the handheld communications device 200 to send and receive information over a wireless cellular network and/or a local area wireless network.

The operating system also includes a Java Virtual Machine (JVM) 302, and a Just In Time (JIT) compiler 304. As will be described below, the JIT compiler 304 is configured to compile native machine code from a set of prefix codes that is associated with a data stream that is encoded with the prefix code set. The native machine code defines a binary tree that corresponds to the prefix code set. The data processing means 202 traverses the prefix code tree by executing the native machine code, and without time-consuming main memory lookups and looping operations.

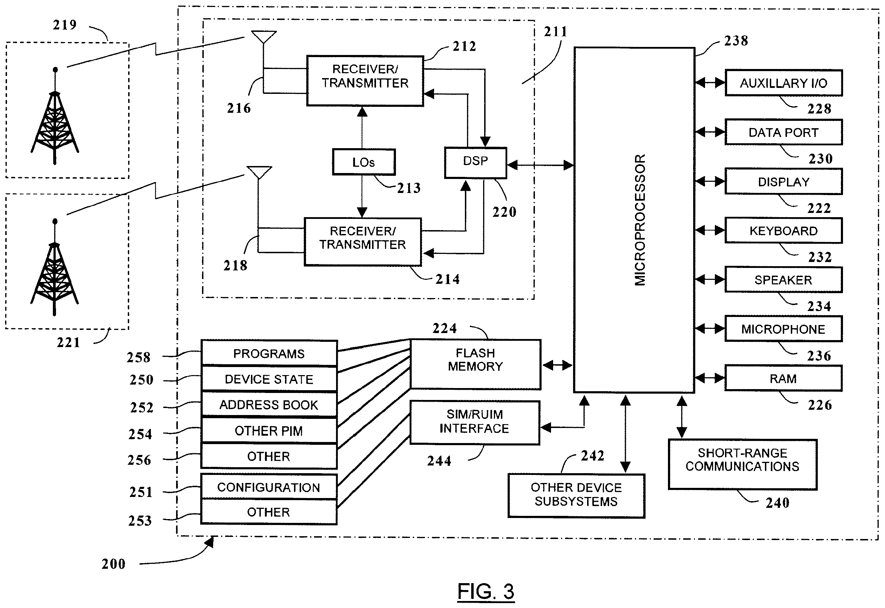

Fig. 3 depicts functional details of the handheld communications device 200. As shown, the handheld communications device 200 incorporates a motherboard that includes a communication subsystem 211, and a microprocessor 238. The communication subsystem 211 performs communication functions, such as data and voice communications, and includes a primary transmitter/receiver 212, a secondary transmitter/receiver 214, a primary internal antenna 216 for the primary transmitter/receiver 212, a secondary internal antenna 218 for the secondary transmitter/receiver 214, and local oscillators (LOs) 213 and one or more digital signal processors (DSP) 220 coupled to the transmitter/receivers 212, 214.

Typically, the communication subsystem 211 sends and receives wireless communication signals over a wireless cellular network via the primary transmitter/receiver 212 and the primary internal antenna 216. Further, typically the communication subsystem 211 sends and receives wireless communication signals over a local area wireless network via the secondary transmitter/receiver 214 and the secondary internal antenna 218.

Preferably, the primary internal antenna 216 is configured for use within a Global System for Mobile Communications (GSM) cellular network or a Code Division Multiple Access (CDMA) cellular network. Further, preferably the secondary internal antenna 218 is configured for use within a WLAN WiFi (IEEE 802.11x) or Bluetooth network. Although the handheld communications device 200 is depicted in Fig. 2 with two antennas, it should be understood that the handheld communications device 200 may instead comprise only a single antenna, with a dual-band antenna being connected to both the primary transmitter/receiver 212 and the secondary transmitter/receiver 214.

Signals received by the primary internal antenna 216 from the wireless cellular network are input to the receiver section of the primary transmitter/receiver 212, which performs common receiver functions such as frequency down conversion, and analog to digital (A/D) conversion, in preparation for more complex communication functions performed by the DSP 220. Signals to be transmitted over the wireless cellular network are processed by the DSP 220 and input to transmitter section of the primary transmitter/receiver 212 for digital to analog conversion, frequency up conversion, and transmission over the wireless cellular network via the primary internal antenna 216.

Similarly, signals received by the secondary internal antenna 218 from the local area wireless network are input to the receiver section of the secondary transmitter/receiver 214, which performs common receiver functions such as frequency down conversion, and analog to digital (A/D) conversion, in preparation for more complex communication functions performed by the DSP 220. Signals to be transmitted over the local area wireless network are processed by the DSP 220 and input to transmitter section of the secondary transmitter/receiver 214 for digital to analog conversion, frequency up conversion, and transmission over the local area wireless network via the secondary internal antenna 218.

The communications device 200 also includes a SIM interface 244 if the handheld communications device 200 is configured for use within a GSM network, and/or a RUIM interface 244 if the handheld communications device 200 is configured for use within a CDMA network. The SIM/RUIM interface 244 is similar to a card-slot into which a SIM/RUIM card can be inserted and ejected like a diskette or PCMCIA card. The SIM/RUIM card holds many key configurations 251, and other information 253 including subscriber identification information, such as the International Mobile Subscriber Identity (IMSI) that is associated with the handheld communications device 200, and subscriber-related information.

The microprocessor 238, in conjunction with the flash memory 224 and the RAM 226, comprises the aforementioned data processing means 202 and controls the overall operation of the device. The data processing means 202 interacts with device subsystems such as the display 222, flash memory 224, RAM 226, auxiliary input/output (I/O) subsystems 228, data port 230, keyboard 232, speaker 234, microphone 236, short-range communications subsystem 240, and device subsystems 242. The data port 230 may comprise a RS-232 port, a Universal Serial Bus (USB) port or other wired data communication port.

As shown, the flash memory 224 includes both computer program storage 258 and program data storage 250, 252, 254 and 256. Computer processing instructions are preferably also stored in the flash memory 224 or other similar non-volatile storage. Other computer processing instructions may also be loaded into a volatile memory such as RAM 226. The computer processing instructions, when accessed from the memory 224, 226 and executed by the microprocessor 238 define the operating system, computer programs, and operating system specific applications. The computer processing instructions may be installed onto the handheld communications device 200 upon manufacture, or may be loaded through the cellular wireless network, the auxiliary I/O subsystem 228, the data port 230, the short-range communications subsystem 240, or the device subsystem 242. In addition to the functions previously described herein, the operating system allows the handheld communications device 200 to operate the display 222, the auxiliary input/output (I/O) subsystems 228, data port 230, keyboard 232, speaker 234, microphone 236, short-range communications subsystem 240, and device subsystems 242.

Typically, the computer programs include communication software that configures the handheld communications device 200 to receive one or more communication services. For instance, preferably the communication software includes internet browser software, e-mail software, telephone software and GPS-mapping software that respectively allow the handheld communications device 200 to communicate with various computer servers over the internet, send and receive e-mail, initiate and receive telephone calls, and view electronic maps. In addition, the computer programs may include still image viewing software that allows the user to view electronic images that are saved in the flash memory 224 or the RAM 226.

In data communication mode, a received text message or web page download will be processed by the communication subsystem 211 and output to the display 222, or alternatively to an auxiliary I/O device 228. A user of the handheld communications device 200 may compose data items such as email messages for example, using the keyboard 232. Such composed items may then be transmitted over the wireless cellular network or the local area wireless network through the communication subsystem 211.

For voice communications, overall operation of the handheld communications device 200 is similar, except that received signals would preferably be output to the speaker 234 and signals for transmission would be generated by a microphone 236. Further, the display 222 may provide an indication of the identity of a calling party, the duration of a voice call, or other voice call related information for example.

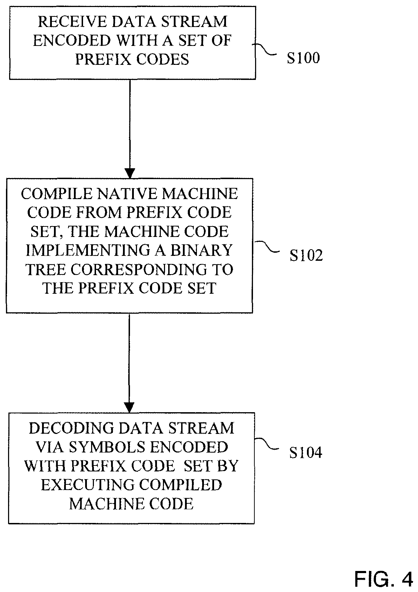

Fig. 4 is a flow chart that depicts, by way of overview, the method implemented in the handheld communications device 200 when decoding a data stream that is encoded with a set of prefix codes.

At step S100, the handheld communications device 200 receives a receive data stream that was encoded with the prefix code set. Typically, the handheld communications device 200 receives the encoded data stream over the wireless cellular network (via the primary transmitter/receiver 212 and the primary internal antenna 216) or the local area wireless network (via the secondary transmitter/receiver 214 and the secondary internal antenna 218). However, the handheld communications device 200 may also receive the encoded data stream via the data port 230.

Preferably, the prefix code set comprises a variable-length prefix code set that was used to entropy-encode the data stream. More preferably, the prefix code set comprises a Huffman prefix code table. As discussed earlier, Huffman tables are often used with the JPEG algorithm for compressing and decompressing the quantized image data. Therefore, typically the received data stream comprises an electronic image that is encoded with a Huffman table, and the handheld communications device 200 receives the Huffman table as a component of the electronic image.

However, the received data stream need not include a prefix code set or a Huffman table. Rather, the operating system of the handheld communications device 200 may include one or more standard prefix code sets, and the received data stream may specify the standard prefix code set that was used to encode the data stream.

Further, although the invention is advantageously used in association with compressed electronic images, the invention is not limited to decompressing electronic images. Rather, since Huffman tables can be used to encode data other than image data, the received data stream can comprise other encoded data streams. For instance, the received data stream can comprise an encoded alphanumeric data stream. In addition, the prefix code table need not be a Huffman table, but may comprise other forms of prefix codes that can be used to encode and decode data streams.

At step S102, the compiler 304 of the handheld communications device 200 compiles machine code from the prefix code set. The machine code implements a binary prefix code tree that corresponds to the prefix code set. Where the prefix code set comprises a Huffman prefix code table, the machine code implements a Huffman tree. Further, the machine code is native to the data processing system 202, in the sense that the machine code is executable directly by the microprocessor 238 without any code conversion. Although the machine code implements a binary prefix code tree, in one of preferred embodiments (discussed below), the compiler 304 does not actually construct a prefix code tree prior to compiling the machine code.

At step S104, the data processing means 202 of the handheld communications device 200 decodes the data stream from the symbols that are encoded in the prefix code table. To do so, the microprocessor 238 executes the native machine code that was compiled at step S102, and thereby traverses the prefix code tree. Although the microprocessor 238 may access the RAM 226 and/or execute loop machine language opcodes to read the encode data stream, preferably the microprocessor 238 does not access the RAM 226 or execute any loop opcodes when traversing the prefix code tree.

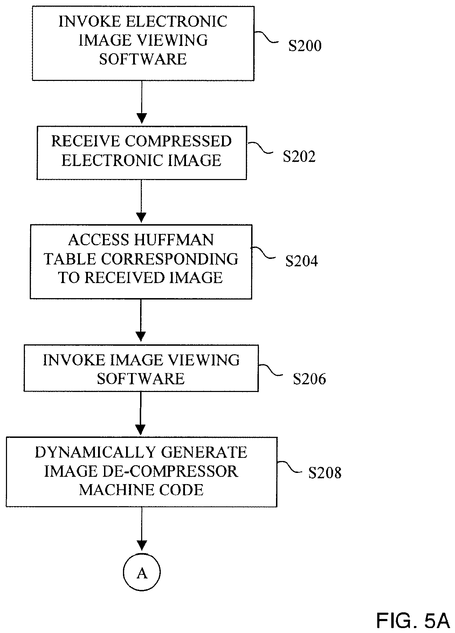

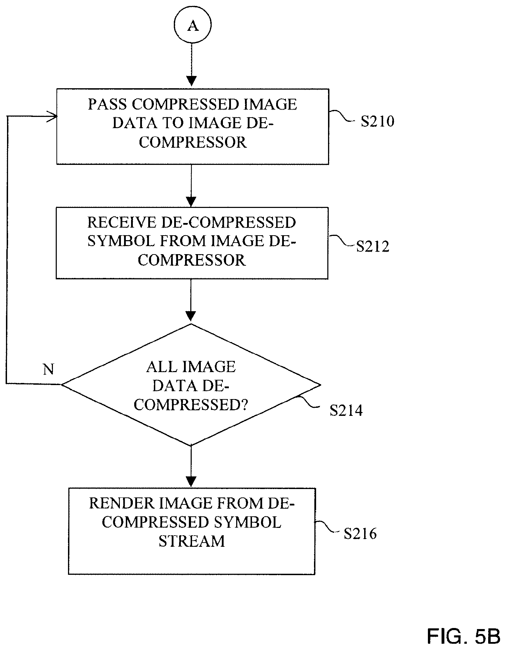

Fig. 5 depicts, in detail, the sequence of steps performed by the handheld communications device 200 when decompressing an electronic image that is compressed with a Huffman table.

At step S200, the user of the handheld communications device 200 invokes one of the image viewing software programs that is installed on the handheld communications device 200, and accesses the compressed electronic image with the invoked communication software. For instance, the user may invoke the internet browser, and access a compressed electronic image that is stored on a remote web server. Alternately, the user may invoke the still image viewer, and access a compressed electronic image that is saved in the flash memory 224 or the RAM 226.

At step S202, the invoked software program receives the compressed electronic image. As discussed above, the user may invoke the internet browser, in which case the image viewing software program receives the electronic image over the wireless cellular network or the local area wireless network. Alternately, the user may invoke the still image viewer, in which case the image viewing software program accesses the electronic image from the flash memory 224 or the RAM 226.

Preferably, the electronic image received at step S202 comprises compressed image data, and a Huffman table. More preferably, the electronic image comprises a JPEG image. Accordingly, at step S204, preferably the invoked software program extracts the Huffman table from the image file header.

However, as discussed above, the compressed electronic image is not limited to a JPEG image, but may comprise other image data streams that are encoded with a Huffman table. Accordingly, in one variation, the received image data stream does not actually include a Huffman table, but instead explicitly or implicitly refers to a standard Huffman table. In this case, at step S204 the image viewing software program accesses the standard Huffman table that is associated with the received image data stream.

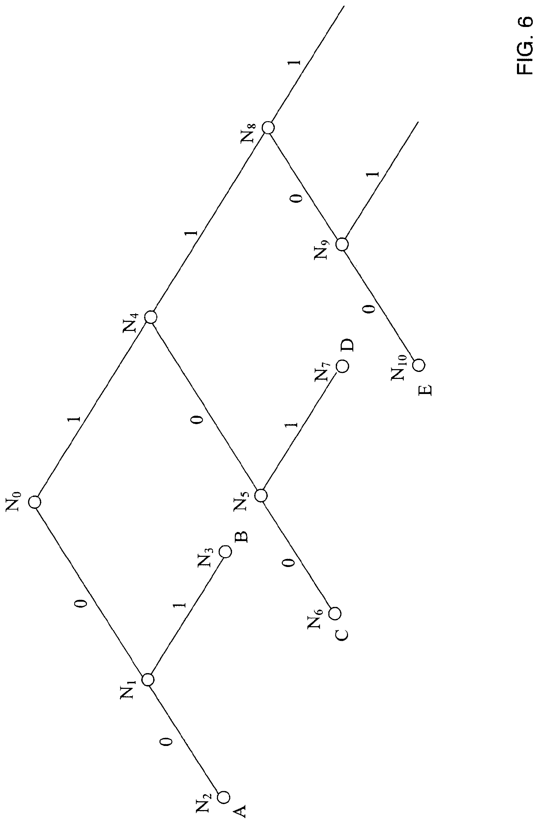

At step S206, the invoked software program invokes the JIT compiler 304 to assist with the decompression of the compressed image data. In response, at step S208, the JIT compiler 304 dynamically generates machine code that defines an image de-compressor procedure. The image de-compressor machine code runs natively on the microprocessor 238, and implements a machine-code-based Huffman tree that corresponds to the Huffman table. Two algorithms which the JIT compiler 304 may use to dynamically generate the image de-compressor machine code will be discussed below, with reference to Figs. 6 to 8.

At step S210, the image viewing software program calls the image de-compressor procedure, passing the compressed image data to the image de-compressor procedure. Preferably, the image viewing software program passes the compressed image data to the image de-compressor procedure via one of the internal registers of the microprocessor 238.

At step S212, in response the image viewing software program receives a de-compressed symbol corresponding to the compressed image data. Preferably, the image de-compressor procedure passes the de-compressed symbol to the invoked software program via one of the internal registers of the microprocessor 238.

As shown by step S214, the image viewing software program repeatedly calls the image de-compressor procedure until all of the receive compressed image data has been de-compressed. The image viewing software program then renders the corresponding image from the decompressed symbol stream, at step S216. Alternately, the image viewing software program may render the image dynamically as it receives the de-compressed symbol stream from the image de-compressor procedure.

Two sample algorithms for generating the image de-compressor machine code will now be described, with reference to Figs. 6 to 9. In these examples, it is assumed that the invoked image viewing software program has the following Huffman table data:

**TABLE 1**

| Huffman Prefix Code | Symbol |
|---|---|
| B'00' | A |
| B'01' | B |
| B'100' | C |
| B'101' | D |
| B'1100' | E |

Fig. 6 is a Huffman tree that corresponds to the aforementioned Huffman table data. In the tree, the Huffman prefix codes B'111' and B'1101' are not associated with any symbol. A discussion of the procedure for constructing the Huffman tree from the Huffman table data is omitted since suitable procedures for constructing the Huffman tree would be well known to persons skilled in this field of technology.

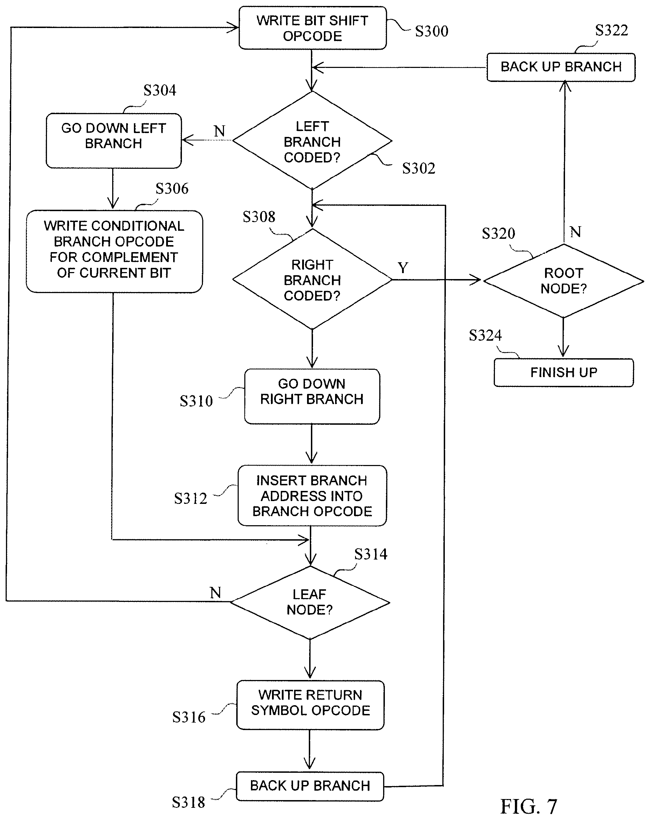

Fig. 7 is a flowchart that depicts one algorithm which the JIT compiler 304 may use to dynamically generate the image de-compressor machine code from the Huffman tree depicted in Fig. 6. Initially, the JIT compiler begins compiling the image de-compressor machine code from the root node (N0) of the Huffman tree.

At step S300, the JIT compiler 304 assigns a current address pointer to the starting memory address in the RAM 226 for the image de-compressor procedure, and writes a shift opcode into this starting memory location. Preferably, the shift is a left shift bit opcode which, when executed by the microprocessor 238, causes the microprocessor 238 to shift the contents of one of its internal general purpose data registers to the left. The invoked software program will pass the compressed image data to the image de-compressor procedure via this data register. Therefore, after execution of the shift opcode, the data register will contain a shifted version of the compressed image data, and the status register of the microprocessor 238 will indicate whether the bit that was shifted out of the data register (the most significant bit) was B'0' or B' 1'.

At step S302, the JIT compiler 304 determines whether the left branch of the current node has been coded. Since the JIT compiler 304 will begin compiling from the root node of the Huffman tree, initially neither the left branch nor the right branch of the root node will have been coded. If the JIT compiler 304 determined, at step S302, that the left branch of the current node was already coded, the JIT compiler 304 jumps to step S308 for coding of the right branch.

On the other hand, if the JIT compiler 304 determined, at step S302, that the left branch of the current node was not already coded, at step S304 the JIT compiler 304 takes the left branch of the current node. At step S306, the JIT compiler 304 advances the current address pointer to the next memory address, and then writes a conditional branch opcode into this new current memory location. The conditional branch opcode, when executed by the microprocessor 238, causes the microprocessor 238 to branch to the memory address specified in the conditional branch opcode if the condition specified in the opcode is satisfied.

Preferably, the conditional branch opcode causes the microprocessor 238 to branch to the specified memory address if the bit that was shifted out of the general purpose register at step S302 was the compliment of the bit associated with the current branch of the Huffman tree. For instance, in the Huffman tree depicted in Fig. 6, the left branch from the root node is associated with the bit B'0'. Therefore, the conditional branch opcode that is written at step S306 will cause the microprocessor 238 to branch to the specified memory address if the bit that was shifted out of the general purpose register at step S302 was B'1'. Processing then continues at step S314.

At step S314, the JIT compiler 304 stops at the next lowest node of the current branch, and then determines whether this node is a leaf node of the Huffman tree (i.e. coding for the current branch is complete). If the new current node is not a leaf node, the JIT compiler 304 returns to step S300 for processing of the new current node.

On the other hand, if the new current node is a leaf node, the JIT compiler 304 advances the current address pointer to the next memory address, and then writes a return opcode into this new current memory location, at step S316. The return opcode, when executed by the microprocessor 238, causes the microprocessor 238 to return to the calling procedure (the image viewing software program that was invoked at step S206) the symbol that was associated with the current node. The JIT compiler 304 then moves back up the current branch to the preceding node, at step S318, and then jumps to step S308 for further processing of the preceding node (the new current node).

At step S308, the JIT compiler 304 determines whether the right branch of the current node has been coded. If the JIT compiler 304 determined, at step S308, that the right branch of the current node was not already coded, at step S310 the JIT compiler 304 takes the right branch of the current node. At step S312, the JIT compiler 304 advances the current address pointer to the next memory address, and then inserts the value of the current address pointer into the conditional branch opcode that was written at step S306. Processing then continues at step S314 for determination of whether the next lowest node of the current branch is a leaf node.

If the JIT compiler 304 determined, at step S308, that the right branch of the current node was already coded, the JIT compiler 304 jumps to step S320 since both branches of the current node will have been coded. At step S320, the JIT compiler 304 determines whether the current node is the root node of the Huffman tree. If the current node is not the root node, the JIT compiler 304 moves back up the current branch to the preceding node, at step S322, and then jumps to step S302 for further processing of the preceding node (the new current node).

On the other hand, if the JIT compiler 304 determined, at step S320, that the current node is the root node of the Huffman tree, further processing of the Huffman tree will be terminated since all branches of the Huffman tree will have been coded.

The following tables trace the generation of the image de-compressor machine code, as the JIT compiler 304 executes the algorithm of Fig. 7 against the Huffman tree depicted in Fig. 6.

### Node N0 (step S300):

```
 BEGIN: SHIFT LEFT
```

### Node N1 (steps S302, S304, S306, S314, S300):

```
 BEGIN: SHIFT LEFT
         IF CF = 1, GO TO <>
         SHIFT LEFT
```

### Node N2 (steps S302, S304, S306, S314, S316):

```
 BEGIN: SHIFT LEFT
         IF CF = 1, GO TO <>
         SHIFT LEFT
         IF CF = 1, GO TO <>
         RETURN SYMBOL "A"; Prefix = B'00
```

### Node N3 (steps S318, S308, S310, S312, S314, S316):

```
 BEGIN: SHIFT LEFT
         IF CF = 1, GO TO <>
         SHIFT LEFT
         IF CF = 1, GO TO <Addr1>
         RETURN SYMBOL "A"; Prefix = B'00
         Addr1: RETURN SYMBOL "B"; Prefix = B'01
```

### Node N4 (steps S318, S308, S320, S322, S302, S308, S310, S312, S314, S300):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
```

### Node N5 (steps S302, S304, S306, S314, S300):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <>
         SHIFT LEFT
```

### Node N6 (steps S302, S304, S306, S314, S316):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <>
         SHIFT LEFT
         IF CF = 1, GO TO <>
         RETURN SYMBOL "C"; Prefix = B'100
```

### Node N7 (steps S318, S308, S310, S312, S314, S316):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <>
         SHIFT LEFT
         IF CF = 1, GO TO <Addr3>
         RETURN SYMBOL "C"; Prefix = B'100
         Addr3: RETURN SYMBOL "D"; Prefix = B'101
```

### Node N8 (steps S318, S308, S320, S322, S302, S308, S310, S312, S314, S300):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <Addr4>
         SHIFT LEFT
         IF CF = 1, GO TO <Addr3>
         RETURN SYMBOL "C"; Prefix = B'100
         Addr3: RETURN SYMBOL "D"; Prefix = B'101
         Addr4: SHIFT LEFT
```

### Node N9 (steps S302, S304, S306, S314, S300):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <Addr4>
         SHIFT LEFT
         IF CF = 1, GO TO <Addr3>
         RETURN SYMBOL "C"; Prefix = B'100
         Addr3: RETURN SYMBOL "D"; Prefix = B'101
         Addr4: SHIFT LEFT
         IF CF = 1, GO TO <>
         SHIFT LEFT
```

### Node N10 (steps S302, S304, S306, S314, S316):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <Addr4>
         SHIFT LEFT
         IF CF = 1, GO TO <Addr3>
         RETURN SYMBOL "C"; Prefix = B'100
         Addr3: RETURN SYMBOL "D"; Prefix = B'101
         Addr4: SHIFT LEFT
         IF CF = 1, GO TO <>
         SHIFT LEFT
         IF CF = 1, GO TO <>
         RETURN SYMBOL "E"; Prefix = B'1100
```

### Error Node (steps S318, S308, S310, S312, S314, S316):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <Addr4>
         SHIFT LEFT
         IF CF = 1, GO TO <Addr3>
         RETURN SYMBOL "C"; Prefix = B'100
         Addr3: RETURN SYMBOL "D"; Prefix = B'101
         Addr4: SHIFT LEFT
         IF CF = 1, GO TO <>
         SHIFT LEFT
         IF CF = 1, GO TO <Addr5>
         RETURN SYMBOL "E"; Prefix = B'1100
         Addr5: RETURN ERROR; Prefix = B'1101
```

### Error Node (steps S318, S308, S320, S322, S302, S308, S310, S312, S314, S316):

```
 BEGIN: SHIFT LEFT
         IF CF = 1, GO TO <Addr2>
         SHIFT LEFT
         IF CF = 1, GO TO <Addr1>
         RETURN SYMBOL "A"; Prefix = B'00
         Addr1: RETURN SYMBOL "B"; Prefix = B'01
         Addr2: SHIFT LEFT
         IF CF = 1, GO TO <Addr4>
         SHIFT LEFT
         IF CF = 1, GO TO <Addr3>
         RETURN SYMBOL "C"; Prefix = B'100
         Addr3: RETURN SYMBOL "D"; Prefix = B'101
         Addr4: SHIFT LEFT
         IF CF = 1, GO TO <Addr6>
         SHIFT LEFT
         IF CF = 1, GO TO <Addr5>
         RETURN SYMBOL "E"; Prefix = B'1100
         Addr5: RETURN ERROR; Prefix = B'1101
         Addr6: RETURN ERROR; Prefix = B'111
```

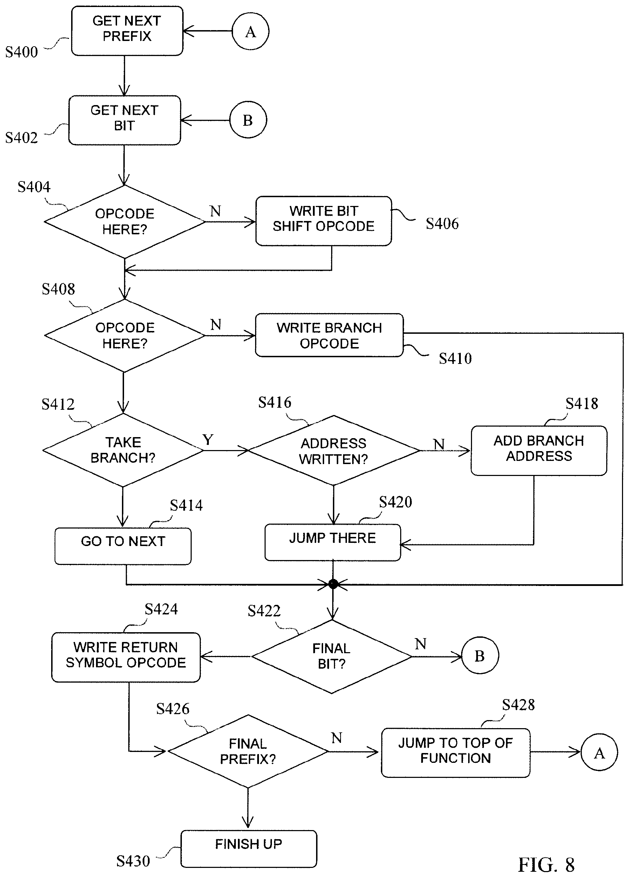

One limitation of the algorithm of Fig. 7 is that it must construct a Huffman tree in RAM 226. Fig. 8 is a flowchart that depicts a preferred algorithm which the JIT compiler 304 uses to dynamically generate the image de-compressor machine code. The algorithm of Fig. 8 is similar to the algorithm of Fig. 7, in that the resulting image de-compressor machine code still implements a Huffman tree. However, in contrast to the algorithm of Fig. 7, the algorithm of Fig. 8 does not require the JIT compiler 304 to construct a Huffman tree to generate the machine code.

Initially, the JIT compiler 304 assigns a current address pointer to the starting memory address in the RAM 226 for the image de-compressor procedure. Then, at step S400, the JIT compiler 304 reads the first Huffman code prefix. At step S402, the JIT compiler 304 reads the first bit of the first Huffman code prefix.

At step S404, the JIT compiler 304 determines whether an opcode has already been written to the current memory location. Initially, the current memory location will not contain any opcode. However, as will become apparent, as the algorithm continues to execute, the current memory location may contain a shift opcode from a previous write step. Accordingly, step S404 speeds up the compilation process by avoiding writing to the RAM 226 if the current memory location already contains a shift opcode.

If the JIT compiler 304 determines, at step S404, that the current memory location does not contain an opcode, at step S406 the JIT compiler 304 writes a shift opcode into the current memory location. Preferably, the shift opcode is a left shift bit opcode which, when executed by the microprocessor 238, causes the microprocessor 238 to shift the contents of one of its internal general purpose data registers to the left. As above, the image viewing software program will pass the compressed image data to the image de-compressor procedure via this data register. Therefore, after execution of the shift opcode, the data register will contain a shifted version of the compressed image data, and the status register of the microprocessor 238 will indicate whether the bit that was shifted out of the data register (the most significant bit) was B'0' or B'1'.

At step S408, the JIT compiler 304 advances the current address pointer, and then determines whether an opcode has already been written to the current memory location. Initially, the current memory location will not contain any opcode. However, as will become apparent, as the algorithm continues to execute, the current memory location may contain a conditional branch opcode from a previous write step. Since a conditional branch opcode may contain a branch address, if the current memory location already contains a conditional branch opcode step S408 ensures that the JIT compiler 304 does not erase that branch address.

However, if the JIT compiler 304 determines, at step S408, that the current memory location does not contain an opcode, at step S410 the JIT compiler 304 writes a conditional branch opcode into the current memory location, and then advances the current address pointer. Processing then continues at step S422.

The conditional branch opcode, when executed by the microprocessor 238, causes the microprocessor 238 to branch to the memory address specified in the conditional branch opcode if the condition specified in the branch opcode is satisfied. The conditional branch opcode written at step S410 will not include the target memory address. This missing parameter will be specified at step S416.

The conditional branch opcode causes the microprocessor 238 to branch to the specified memory address if the bit that is shifted out of the general purpose register by the shift opcode (in the preceding memory location) is the compliment of the current bit (as determined at step S402). For instance, if the first Huffman prefix code to be coded is B'00', the first bit will be B'0', in which case the conditional branch opcode that is written at step S408 will cause the microprocessor 238 to branch to the specified memory address if the bit that was shifted out of the general purpose register by the preceding shift opcode is B'1'.

If the JIT compiler 304 determines, at step S408, that the current memory location already contains a conditional branch opcode, processing continues at step S412. At step S412, the JIT compiler 304 determines whether the current bit matches the condition specified in the conditional branch opcode. If not, the JIT compiler 304 simply advances the current address pointer at step S414, since the branch has not yet been taken. Processing then continues at step S422.

On the other hand, if the JIT compiler 304 determines, at step S412, that the current bit matches the condition specified in the conditional branch opcode, the JIT compiler 304 determines, at step S416, whether the conditional branch opcode already contains a branch address. If not, the JIT compiler 304 inserts the last current address into the conditional branch opcode, at step S418, since the last current address will be the address of memory location that follows the last opcode that was written (at step S406 or step S424) into the RAM 226. Processing then continues at step S422.

However, if the JIT compiler 304 determines, at step S416, that the conditional branch opcode already contains a branch address, the JIT compiler 304 advances the current address pointer to the specified branch address, at step S420, and then proceeds to step S422.

At step S422, the JIT compiler 304 determines whether the current bit is the last bit of the current Huffman prefix code. If not, the JIT compiler 304 proceeds to step S402 where it reads the next bit of the current Huffman prefix code. Processing then continues with the new current bit, as discussed above.

However, if the JIT compiler 304 determines, at step S422, that the current bit is the last bit of the current Huffman prefix code, at step S424 the JIT compiler 304 writes a return opcode into the current memory location which, when executed by the microprocessor 238, causes the microprocessor 238 to return the value of the associated symbol to the image viewing software program that invoked the image de-compressor procedure.

At step S426, the JIT compiler 304 determines whether the current prefix code is the last prefix code to be encoded into the image de-compressor procedure. If not, the JIT compiler 304 proceeds to step S400 where it reads the next Huffman prefix code. Otherwise, processing terminates at step S430 by inserting the last current address into each of the conditional branch opcodes for which a target branch address was not previously specified. The JIT compiler 304 also writes a return opcode into the last current memory location, thereby causing the image de-compressor procedure to return an error code symbol for any erroneous Huffman prefix codes received from the calling software program.

Table 2 is a pseudo-code implementation of the algorithm of Fig. 8.

### TABLE 2

```
 For Each HuffmanCode
       CurrentAddress = Start of function
       For Each Bit in HuffmanCode
 // If no opcode exists, insert a shift opcode (if an opcode does exist,
 // it will be a shift operation)
               If OpCode at CurrentAddress is Not Set
                       Insert shift instruction at CurrentAddress
                      Advance CurrentAddress
                      EndOfFunction = CurrentAddress
               Else
                      Advance CurrentAddress
               End If
 // The opcode after the shift will be a branch. If it does not exist,
 // insert a branch opcode (fill in destination address later). Set the
 // condition of the branch to compliment of current Bit (!Bit), so that
 // the branch will be skipped by the CPU if it is processing the
 // current Bit (this is more efficient)
               If OpCode at CurrentAddress is Not Set
                       Insert branch instruction without address filled in,
                      branch condition set to !Bit
                      Advance CurrentAddress
                      EndOfFunction = CurrentAddress
               Else
 // CurrentAddress points to a branch instruction. Retrieve
 // destination address and condition of branch instruction.
                      BranchAddress = GetBranchAddress(CurrentAddress)
                      BranchCondition = GetBranchCondition(CurrentAddress)
 // Take the branch if the branch condition matches the current Bit.
 // Otherwise, skip over branch instruction. If branch instruction does
 // not have an address set, set it to the end of the function (where
 // new instructions are inserted)
                       If BranchCondition = Bit
                              If BranchAddress is Not Set
 // Fill in the branch address since branch is being taken (the branch
 // will point to the current end of the function, which will soon
 // contain instructions)
                                     Set Branch Address to EndOfFunction
                                     Set CurrentAddresss to EndOfFunction
                              Else
 // Jump to the address specified in the branch
                                     Set CurrentAddress to BranchAddress
                              End If
                      Else
 // Skip over branch instruction; condition did not match current Bit
                              Advance CurrentAddress
                      End If
               End If
 // Insert epilog section if entire symbol has been decoded. Typically,
 // epilog instructions return symbol associated with Huffman Code
               If Bit is last in HuffmanCode
                       Insert epilog instructions at CurrentAddress
                      Advance CurrentAddress
                      EndOfFunction = CurrentAddress
               End If
       Next Bit
       Next HuffmanCode
 // The SymbolNotFound instructions will typically cause subroutine to
 // return with an error code
 Insert SymbolNotFound instructions at EndOfFunction
 // Fill in address for any leftover branches which are not set (which
 // represent "invalid" or unused Huffman codes)
 For each Instruction in Generated Function
        If Instruction is Branch and Address is Not Set
               Set Branch Address to EndOfFunction
       End If
       Next Instruction
```

Table 3 contains Intel XScale processor opcodes for an image de-compressor that would be produced by the JIT compiler 304 after executing the pseudo-code of Table 2 against the Huffman tree depicted in Fig. 6. The opcodes included in Table 3 have the following meanings:
LSL R#, R#, # - Logical Shift Left register R# by # of bits specified.
   The bit shifted out is shifted into the "carry" bit of the CPU flags register.
BCS <label> - Branch if Carry Set.
   If the carry bit is set in the CPU flags register, jump to the label specified. If the carry bit is not set, the instruction does nothing and execution continues at the following instruction.
BCC <label> - Branch if Carry Clear (not seen in this code).
   If the carry bit is not set in the CPU flags register, jump to the label specified. If the carry bit is set, the instruction does nothing and execution continues at the following instruction.
MOV R#, # - Move the immediate # into R#
   BX LR - Exit subroutine, return to caller
   Huff_## - Label

**TABLE 3**

| HuffFunc; | Function entrypoint |
|---|---|
| | LSL R0,R0,#1 |
| | BCS Huff_18 |
| | LSL R0,R0,#1 |
| | BCS Huff_10 |
| | MOV R1, "A" |
| | BX LR |
| Huff_10 | MOV R1, "B" |
| | BX LR |
| Huff_18 | LSL R0,R0,#1 |
| | BCS Huff_30 |
| | LSL R0,R0,#1 |
| | BCS Huff_28 |
| | MOV R1, "C" |
| | BX LR |
| Huff_28 | MOV R1, "D" |
| | BX LR |
| Huff_30 | LSL R0,R0,#1 |
| | BCS Huff_3e |
| | LSL R0,R0,#1 |
| | BCS Huff_3e |
| | MOV R1, "E" |
| Huff_3e | BX LR |

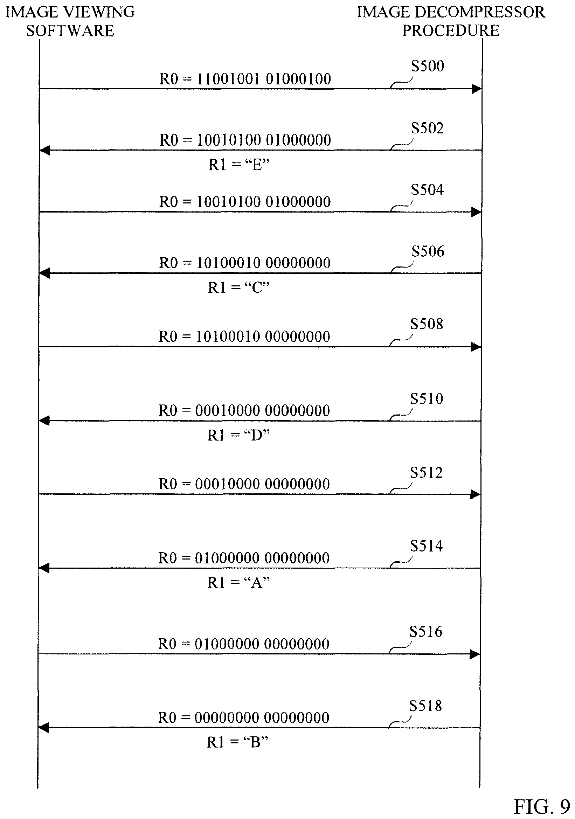

The operation of the image de-compressor procedure of Table 3 will be discussed with reference to data flow diagram of Fig. 9. In this example, image viewing software program passes the compressed image data stream to the image de-compressor procedure via the general purpose register R0, and receives the decompressed symbol stream from the image de-compressor procedure via the general purpose register R1.

At step S500, the image viewing software program calls the image de-compressor procedure, with R0 = 11001001 01000100 (i.e. Huffman prefix codes E, C, D, A, B). In response, the microprocessor 238 executes the LSL R0,R0,#1 instruction, which shifts the contents of register R0 one bit left, thereby setting the carry flag. After this step, R0= 10010010 10001000.

The microprocessor 238 then executes the BCS Huff_18 instruction. Since the carry flag is set, this instruction directs the microprocessor 238 to branch to the Huff_18 memory location. The microprocessor 238 executes the LSL R0,R0,#1 instruction (at Huff_18), which shifts the contents of register R0 one bit left, thereby setting the carry flag. After this step, R0 = 00100101 00010000.

The microprocessor 238 then executes the BCS Huff_30 instruction. Since the carry flag is set, this instruction directs the microprocessor 238 to branch to the Huff_30 memory location. The microprocessor 238 executes the LSL R0,R0,#1 instruction (at Huff_30), which shifts the contents of register R0 one bit left, thereby clearing the carry flag. After this step, R0 = 01001010 00100000.

The microprocessor 238 then executes the BCS Huff_3e instruction. Since the carry flag is clear, this instruction directs the microprocessor 238 to ignore the branch, and execute the following LSL R0,R0,#1 instruction. The microprocessor 238 shifts the contents of register R0 one bit left, thereby clearing the carry flag. After this step, R0 = 10010100 01000000.

The microprocessor 238 then executes the following BCS Huff_3e instruction. Since the carry flag is clear, this instruction directs the microprocessor 238 to ignore the branch, and execute the MOV R1, "E" instruction. The microprocessor 238 loads register R1 with specified symbol, and returns to the image viewing software program, at step S502. After this step, R0 = 10010100 01000000.

At step S504, the image viewing software program calls the image de-compressor procedure again, with R0 = 10010100 01000000 (i.e. Huffman prefix codes C, D, A, B). In response, the microprocessor 238 executes the LSL R0,R0,#1 instruction, which shifts the contents of register R0 one bit left, thereby setting the carry flag. After this step, R0 = 00101000 10000000.

The microprocessor 238 then executes the BCS Huff_18 instruction. Since the carry flag is set, this instruction directs the microprocessor 238 to branch to the Huff_18 memory location. The microprocessor 238 executes the LSL R0,R0,#1 instruction (at Huff_18), which shifts the contents of register R0 one bit left, thereby clearing the carry flag. After this step, R0 = 01010001 00000000.

The microprocessor 238 then executes the BCS Huff_30 instruction. Since the carry flag is clear, this instruction directs the microprocessor 238 to ignore the branch, and execute the following LSL R0,R0,#1 instruction. The microprocessor 238 shifts the contents of register R0 one bit left, thereby clearing the carry flag. After this step, R0 = 10100010 00000000.

The microprocessor 238 then executes the following BCS Huff_28 instruction. Since the carry flag is clear, this instruction directs the microprocessor 238 to ignore the branch, and to execute the MOV R1, "C" instruction. The microprocessor 238 loads register R1 with specified symbol, and returns to the image viewing software program, at step S506. After this step, R0 = 10100010 00000000.

At step S508, the image viewing software program calls the image de-compressor procedure again, with R0 = 10100010 00000000 (i.e. Huffman prefix codes D, A, B). In response, the microprocessor 238 executes the LSL R0,R0,#1 instruction, which shifts the contents of register R0 one bit left, thereby setting the carry flag. After this step, R0 = 01000100 00000000.

The microprocessor 238 then executes the BCS Huff_18 instruction. Since the carry flag is set, this instruction directs the microprocessor 238 to branch to the Huff_18 memory location. The microprocessor 238 executes the LSL R0,R0,#1 instruction (at Huff_18), which shifts the contents of register R0 one bit left, thereby clearing the carry flag. After this step, R0 = 10001000 00000000.

The microprocessor 238 then executes the BCS Huff_30 instruction. Since the carry flag is clear, this instruction directs the microprocessor 238 to ignore the branch, and to execute the following LSL R0,R0,#1 instruction. The microprocessor 238 shifts the contents of register R0 one bit left, thereby setting the carry flag. After this step, R0 = 00010000 00000000.

The microprocessor 238 then executes the BCS Huff_28 instruction. Since the carry flag is set, this instruction directs the microprocessor 238 to branch to the Huff_28 memory location. The microprocessor 238 executes the MOV R1, "D" instruction (at Huff_28). The microprocessor 238 loads register R1 with the specified symbol, and returns to the image viewing software program, at step S510. After this step, R0 = 00010000 00000000.

Further detailed analysis of the image de-compressor procedure is not required. At step S512, the image viewing software program calls the image de-compressor procedure again, with R0 = 00010000 00000000 (i.e. Huffman prefix codes A, B). In response, the microprocessor 238 loads register R1 with the symbol "A", and returns to the image viewing software program, at step S514. After this step, R0 = 01000000 00000000.

At step S516, the image viewing software program calls the image de-compressor procedure again, with R0 = 01000000 00000000 (i.e. Huffman prefix code B). In response, the microprocessor 238 loads register R1 with the symbol "B", and returns to the image viewing software program, at step S518. After this step, R0 = 00000000 00000000.

As will be apparent, the image de-compressor receives the image data stream via general purpose register R0, and returns the corresponding decompressed symbol data stream via general purpose register R1, without the microprocessor 238 performing time-consuming lookups to the RAM 226 to access a Huffman tree. Further, although the image viewing software program that invoked the image de-compressor may access the RAM 226 and/or execute loop machine language opcodes to read the encoded data stream, the image de-compressor traverses the machine-code-based Huffman tree without the microprocessor 238 performing time-consuming looping operations. As a result, the speed of the image decoding operation is improved over conventional image decoding algorithms.

The scope of the monopoly desired for the invention is defined by the claims appended hereto, with the foregoing description being merely illustrative of the preferred embodiment of the invention. Persons of ordinary skill may envisage modifications to the described embodiment which, although not explicitly suggested herein, do not depart from the scope of the invention, as defined by the appended claims.

## Claims

1. A method of decoding encoded data comprising compressed image data at a computing device, comprising the steps of:
receiving (S100) at said computing device data encoded with a set of prefix codes;
at the computing device writing (S102) native machine code for execution by the computing device, the native machine code providing an implementation of a binary prefix code tree corresponding to the prefix code set, and
decoding (S104) the encoded data by traversing the prefix code tree, the traversing the prefix code tree comprising executing the native machine code at the computing device in response to the encoded data;
**characterized in that**:
the implementation includes shift opcodes, branch opcodes, each corresponding to a node of the binary prefix code tree which is not a leaf node, and return opcodes, each corresponding to a leaf node of the binary prefix code tree, and excluding loop opcodes.

2. The method according to Claim 1, wherein the native machine code consists of any of the shift opcodes, the branch opcodes, register load opcodes, and return opcodes.

3. The method according to Claim 1 or Claim 2, wherein the data receiving comprises receiving the encoded data with the set of prefix codes.

4. The method according to any one of Claims 1 to 3, wherein the computing device is a handheld computing device.

5. The method according to any one of Claims 1 to 4, wherein the computing device comprises a processing unit, and a main memory coupled to the processing unit, and the traversing the prefix code tree comprises executing the machine code at the processing unit without accessing the main memory.

6. The method according to Claim 1, wherein the computing device comprises a data register maintaining a portion of the encoded data, the prefix code tree comprises a plurality of nodes, at least one of the branch opcodes comprises a bit test opcode, one of the bit test opcodes being associated with one of the nodes, and the traversing the prefix code tree comprises traversing the one node by executing the associated one bit test opcode in association with the data register portion.

7. The method according to Claim 6, wherein one of the nodes has a pair of branches associated therewith, and the traversing the prefix code tree comprises navigating one branch of the branch pair by executing one of the shift opcodes in response to one outcome of the execution of the one bit test opcode, and navigating another branch of the branch pair by branching to another of the bit test opcodes in response to another outcome of execution of the one bit test opcode.

8. The method according to Claim 7, wherein one of the nodes comprises a leaf, the leaf being associated with the decoded data, and the traversing the prefix code tree comprises navigating to the leaf by executing a return opcode in response to one outcome of the execution of the one bit test opcode, the return opcode returning the decoded data upon execution thereof.

9. A computing device configured for decoding encoded data comprising compressed image data, the computing device comprising:
a data receiver configured for receiving data encoded with a set of prefix codes; and
a processing unit coupled to the data receiver, the processing unit being configured to dynamically write native machine code for execution by the processing unit, the processing unit being further configured to decode the encoded data with the implementation of the prefix code tree by executing the native machine code in response to the encoded data,
**characterized in that**:
the native machine code provides an implementation of a binary prefix code tree corresponding to the prefix code set, the implementation including shift opcodes, branch opcodes, each corresponding to a node of the binary prefix code tree which is not a leaf node, and return opcodes, each corresponding to a leaf node of the binary prefix code tree, and excluding loop opcodes.

10. The computing device according to Claim 9, wherein the native machine code consists of any of the shift opcodes, the branch opcodes, register load opcodes, and return opcodes.

11. The computing device according to Claim 9 or Claim 0, wherein the data receiver is configured to receive the encoded data with the set of prefix codes.

12. The computing device according to any one of Claims 9 to 11, wherein the computing device comprises a handheld computing device.

13. The computing device according to any one of Claims 9 to 12, further comprising a main memory coupled to the processing unit, and the processing unit is configured to execute the machine code without accessing the main memory.

14. The computing device according to Claim 9, wherein the processing unit comprises a data register maintaining a portion of the encoded data, the prefix code tree comprises a plurality of nodes, at least one of the branch opcodes comprises a bit test opcode, one of the bit test opcodes being associated with one of the nodes, and the processing unit is configured by the implementation of the binary prefix code tree to traverse the one node by executing the associated one bit test opcode in association with the register data portion.

15. The computing device according to Claim 14, wherein one of the nodes has a pair of branches associated therewith, and the processing unit is configured by the implementation of the binary prefix code tree to navigate one branch of the branch pair by executing one of the shift opcodes in response to one outcome of the execution of the one bit test opcode, and to navigate another branch of the branch pair by branching to another of the bit test opcodes in response to another outcome of the execution of the one bit test opcode.

16. The computing device according to Claim 14, wherein one of the nodes comprises a leaf, the leaf being associated with decoded data, and the processing unit is configured by the implementation of the binary prefix code tree to navigate to the leaf by executing a return opcode in response to one outcome of the execution of the one bit test opcode, when executed the return opcode directing the processing unit to return the decoded data.

17. A computer readable medium carrying processing instructions for a handheld communications device, the processing instructions, when executed by a computer processor of the handheld communications device, enabling the handheld communications device to implement the method according to any one of Claims 1 to 8.

## Patentansprüche

1. Verfahren zum Decodieren von codierten Daten, die komprimierte Bilddaten aufweisen, an einer Computervorrichtung, das die Schritte aufweist:
Empfangen (S100) von Daten, die mit einem Satz von Präfixcodes codiert sind, an der Computervorrichtung;
Schreiben (S102), an der Computervorrichtung, von nativem Maschinencode zur Ausführung durch die Computervorrichtung, wobei der native Maschinencode eine Implementierung eines binären Präfixcodebaums entsprechend dem Präfixcodesatz vorsieht; und
Decodieren (S104) der codierten Daten durch Durchlaufen des Präfixcodebaums, wobei das Durchlaufen des Präfixcodebaums aufweist ein Ausführen des nativen Maschinencodes an der Computervorrichtung in Reaktion auf die codierten Daten;
**dadurch gekennzeichnet, dass**:
die Implementierung Shift-Opcodes, Branch-Opcodes, die jeweils einem Knoten des binären Präfixcodebaums entsprechen, der kein Blattknoten ist, und Return-Opcodes, die jeweils einem Blattknoten des binären Präfixcodebaums entsprechen, umfassen und Loop-Opcodes ausschließen.

2. Das Verfahren gemäß Anspruch 1, wobei der native Maschinencode aus den Shift-Opcodes, den Branch-Opcodes, Register-Load-Opcodes und Return-Opcodes besteht.

3. Das Verfahren gemäß Anspruch 1 oder Anspruch 2, wobei das Empfangen von Daten ein Empfangen der codierten Daten mit dem Satz von Präfixcodes aufweist.

4. Das Verfahren gemäß einem der Ansprüche 1 bis 3, wobei die Computervorrichtung eine handgehaltene Computervorrichtung ist.

5. Das Verfahren gemäß einem der Ansprüche 1 bis 4, wobei die Computervorrichtung eine Verarbeitungseinheit und einen Hauptspeicher gekoppelt mit der Verarbeitungseinheit aufweist, und das Durchlaufen des Präfixcodebaums ein Ausführen des Maschinencodes an der Verarbeitungseinheit aufweist, ohne auf den Hauptspeicher zuzugreifen.

6. Das Verfahren gemäß Anspruch 1, wobei die Computervorrichtung ein Datenregister aufweist, das einen Teil der codierten Daten enthält, wobei der Präfixcodebaum eine Vielzahl von Knoten aufweist, wobei zumindest einer der Branch-Opcodes einen Bit-Test-Opcode aufweist, wobei einer der Bit-Test-Opcodes mit einem der Knoten assoziiert ist, und das Durchlaufen des Präfixcodebaums ein Durchlaufen des einen Knotens aufweist durch Ausführen des assoziierten einen Bit-Test-Opcodes in Assoziation mit dem Datenregisterteil.

7. Das Verfahren gemäß Anspruch 6, wobei einer der Knoten ein Paar von damit assoziierten Zweigen hat, und das Durchlaufen des Präfixcodebaums aufweist ein Navigieren eines Zweigs des Zweigpaares durch Ausführen eines der Shift-Opcodes in Reaktion auf ein Ergebnis der Ausführung des einen Bit-Test-Opcodes, und Navigieren eines anderen Zweigs des Zweigpaares durch Verzweigen zu einem anderen der Bit-Test-Opcodes in Reaktion auf ein anderes Ergebnis einer Ausführung des einen Bit-Test-Opcodes.

8. Das Verfahren gemäß Anspruch 7, wobei einer der Knoten ein Blatt aufweist, wobei das Blatt mit den decodierten Daten assoziiert ist, und das Durchlaufen des Präfixcodebaums ein Navigieren zu dem Blatt aufweist durch Ausführen eines Return-Opcodes in Reaktion auf ein Ergebnis der Ausführung des einen Bit-Test-Opcodes, wobei der Return-Opcode bei seiner Ausführung die decodierten Daten zurückgibt.

9. Eine Computervorrichtung, die konfiguriert ist zum Decodieren von codierten Daten, die komprimierte Bilddaten aufweisen, wobei die Computervorrichtung aufweist:
einen Datenempfänger, der konfiguriert ist zum Empfangen von Daten, die mit einem Satz von Präfixcodes codiert sind; und
eine Verarbeitungseinheit, die mit dem Datenempfänger gekoppelt ist,
wobei die Verarbeitungseinheit konfiguriert ist zum dynamischen Schreiben von nativem Maschinencode zur Ausführung durch die Verarbeitungseinheit,
wobei die Verarbeitungseinheit weiter konfiguriert ist zum Decodieren der codierten Daten mit der Implementierung des Präfixcodebaums durch Ausführen des nativen Maschinencodes in Reaktion auf die codierten Daten,
**dadurch gekennzeichnet, dass**:
der native Maschinencode eine Implementierung eines binären Präfixcodebaums entsprechend dem Präfixcodesatz vorsieht, wobei die Implementierung Shift-Opcodes, Branch-Opcodes, die jeweils einem Knoten des binären Präfixcodebaums entsprechen, der kein Blattknoten ist, und Return-Opcodes, die jeweils einem Blattknoten des binären Präfixcodebaums entsprechen, umfassen und Loop-Opcodes ausschließen.

10. Die Computervorrichtung gemäß Anspruch 9, wobei der native Maschinencode aus den Shift-Opcodes, den Branch-Opcodes, Register-Load-Opcodes und Return-Opcodes besteht.

11. Die Computervorrichtung gemäß Anspruch 9 oder Anspruch 10, wobei der Datenempfänger konfiguriert ist zum Empfangen der codierten Daten mit dem Satz von Präfixcodes.

12. Die Computervorrichtung gemäß einem der Ansprüche 9 bis 11, wobei die Computervorrichtung eine handgehaltene Computervorrichtung aufweist.

13. Die Computervorrichtung gemäß einem der Ansprüche 9 bis 12, die weiter einen Hauptspeicher gekoppelt mit der Verarbeitungseinheit aufweist, und die Verarbeitungseinheit konfiguriert ist zum Ausführen des Maschinencodes, ohne auf den Hauptspeicher zuzugreifen.

14. Die Computervorrichtung gemäß Anspruch 9, wobei die Verarbeitungseinheit ein Datenregister aufweist, das einen Teil der codierten Daten enthält, wobei der Präfixcodebaum eine Vielzahl von Knoten aufweist, wobei zumindest einer der Branch-Opcodes einen Bit-Test-Opcode aufweist, wobei einer der Bit-Test-Opcodes mit einem der Knoten assoziiert ist, und die Verarbeitungseinheit konfiguriert ist, durch die Implementierung des binären Präfixcodebaums, zum Durchlaufen des einen Knotens durch Ausführen des assoziierten einen Bit-Test-Opcodes in Assoziation mit dem Datenregisterteil.

15. Die Computervorrichtung gemäß Anspruch 14, wobei einer der Knoten ein Paar von damit assoziierten Zweigen hat, und die Verarbeitungseinheit konfiguriert ist, durch die Implementierung des binären Präfixcodebaums, zum Navigieren eines Zweigs des Zweigpaares durch Ausführen eines der Shift-Opcodes in Reaktion auf ein Ergebnis der Ausführung des einen Bit-Test-Opcodes, und zum Navigieren eines anderen Zweigs des Zweigpaares durch Verzweigen zu einem anderen der Bit-Test-Opcodes in Reaktion auf ein anderes Ergebnis der Ausführung des einen Bit-Test-Opcodes.

16. Die Computervorrichtung gemäß Anspruch 14, wobei einer der Knoten ein Blatt aufweist, wobei das Blatt mit decodierten Daten assoziiert ist, und die Verarbeitungseinheit konfiguriert ist, durch die Implementierung des binären Präfixcodebaums, zum Navigieren zu dem Blatt durch Ausführen eines Return-Opcodes in Reaktion auf ein Ergebnis der Ausführung des einen Bit-Test-Opcodes, wobei der Return-Opcode bei Ausführung die Verarbeitungseinheit anweist, die decodierten Daten zurückzugeben.

17. Ein computerlesbares Medium mit Verarbeitungsanweisungen für eine handgehaltene Kommunikationsvorrichtung, wobei die Verarbeitungsanweisungen bei Ausführung durch einen Computerprozessor der handgehaltenen Kommunikationsvorrichtung der handgehaltenen Kommunikationsvorrichtung ermöglicht, das Verfahren gemäß einem der Ansprüche 1 bis 8 zu implementieren.

## Revendications

1. Procédé de décodage de données codées comprenant des données d'images compressées au niveau d'un dispositif informatique, comprenant les étapes consistant à :
recevoir (S100), au niveau dudit dispositif informatique, des données codées avec un ensemble de codes préfixes ;
écrire (S102), au niveau du dispositif informatique, un code machine natif destiné à être exécuté par le dispositif informatique, le code machine natif fournissant une implémentation d'un arbre de codes préfixes binaires correspondant à l'ensemble de codes préfixes, et
décoder (S104) les données codées en parcourant l'arbre de codes préfixes, le parcours de l'arbre de codes préfixes comprenant l'exécution du code machine natif au niveau du dispositif informatique en réponse aux données codées ;
**caractérisé en ce que** :
l'implémentation comporte des codes d'opération de décalage, des codes d'opération de branche, correspondant chacun à un noeud de l'arbre de codes préfixes binaires qui n'est pas un noeud feuille, et des codes d'opération de retour, correspondant chacun à un noeud feuille de l'arbre de codes préfixes binaires, et excluant des codes d'opération de boucle.

2. Procédé selon la revendication 1, dans lequel le code machine natif est constitué de quelconques codes parmi des codes d'opération de décalage, des codes d'opération de branche, des codes d'opération de chargement de registre, et des codes d'opération de retour.

3. Procédé selon la revendication 1 ou la revendication 2, dans lequel la réception de données comprend la réception des données codées avec l'ensemble de codes préfixes.

4. Procédé selon l'une quelconque des revendications 1 à 3, dans lequel le dispositif informatique est un dispositif informatique portatif.

5. Procédé selon l'une quelconque des revendications 1 à 4, dans lequel le dispositif informatique comprend une unité de traitement, et une mémoire principale couplée à l'unité de traitement, et le parcours de l'arbre de codes préfixes comprend l'exécution du code machine au niveau de l'unité de traitement sans accéder à la mémoire principale.

6. Procédé selon la revendication 1, dans lequel le dispositif informatique comprend un registre de données maintenant une partie des données codées, l'arbre de codes préfixes comprend une pluralité de noeuds, au moins l'un des codes d'opération de branche comprend un code d'opération de test de bit, l'un des codes d'opération de test de bit étant associé à l'un des noeuds, et le parcours de l'arbre de codes préfixes comprend le parcours du noeud en exécutant le code d'opération de test de bit associé en association avec la partie de registre de données.

7. Procédé selon la revendication 6, dans lequel l'un des noeuds a une paire de branches associées à celui-ci, et le parcours de l'arbre de codes préfixes comprend la navigation dans une branche de la paire de branches en exécutant l'un des codes d'opération de décalage en réponse à un résultat de l'exécution du code opération de test de bit, et la navigation dans une autre branche de la paire de branches en se branchant à un autre des codes d'opération de test de bit en réponse à un autre résultat d'exécution du code opération de test de bit.

8. Procédé selon la revendication 7, dans lequel l'un des noeuds comprend une feuille, la feuille étant associée aux données décodées, et le parcours de l'arbre de codes préfixes comprend la navigation jusqu'à la feuille en exécutant un code d'opération de retour en réponse à un résultat de l'exécution du code d'opération de test de bit, le code d'opération de retour renvoyant les données décodées lors d'exécution de celui-ci.

9. Dispositif informatique configuré pour décoder des données codées comprenant des données d'images compressées, le dispositif informatique comprenant :
un récepteur de données configuré pour recevoir des données codées avec un ensemble de codes préfixes ; et
une unité de traitement couplée au récepteur de données, l'unité de traitement étant configurée pour écrire dynamiquement un code machine natif destiné à être exécuté par l'unité de traitement, l'unité de traitement étant en outre configurée pour décoder les données codées avec l'implémentation de l'arbre de codes préfixes en exécutant le code machine natif en réponse aux données codées,
**caractérisé en ce que** :
le code machine natif fournit une implémentation d'un arbre de codes préfixes binaires correspondant à l'ensemble de codes préfixes, l'implémentation comportant des codes d'opération de décalage, des codes d'opération de branche, correspondant chacun à un noeud de l'arbre de codes préfixes binaires qui n'est pas un noeud feuille, et des codes d'opération de retour, correspondant chacun à un noeud feuille de l'arbre de codes préfixes binaires, et excluant des codes d'opération de boucle.

10. Dispositif informatique selon la revendication 9, dans lequel le code machine natif est constitué de quelconques codes parmi des codes d'opération de décalage, des codes d'opération de branche, des codes d'opération de charge de registre, et des codes d'opération de retour.

11. Dispositif informatique selon la revendication 9 ou la revendication 10, dans lequel le récepteur de données est configuré pour recevoir les données codées avec l'ensemble de codes préfixes.

12. Dispositif informatique selon l'une quelconque des revendications 9 à 11, le dispositif informatique consistant en un dispositif informatique portatif.

13. Dispositif informatique selon l'une quelconque des revendications 9 à 12, comprenant en outre une mémoire principale couplée à l'unité de traitement, et l'unité de traitement est configurée pour exécuter le code machine sans accéder à la mémoire principale.

14. Dispositif informatique selon la revendication 9, dans lequel l'unité de traitement comprend un registre de données maintenant une partie des données codées, l'arbre de codes préfixes comprend une pluralité de noeuds, au moins l'un des codes d'opération de branche comprend un code d'opération de test de bit, l'un des codes d'opération de test de bit étant associé à l'un des noeuds, et l'unité de traitement est configurée par l'implémentation de l'arbre de codes préfixes binaires pour parcourir le noeud en exécutant le code d'opération de test de bit associé en association avec la partie de données de registre.

15. Dispositif informatique selon la revendication 14, dans lequel l'un des noeuds a une paire de branches associées à celui-ci, et l'unité de traitement est configurée par l'implémentation de l'arbre de codes préfixes binaires pour naviguer dans une branche de la paire de branches en exécutant l'un des codes d'opération de décalage en réponse à un résultat de l'exécution du code d'opération de test de bit, et pour naviguer dans une autre branche de la paire de branches en se branchant à un autre des codes d'opération de test de bit en réponse à un autre résultat de l'exécution du code d'opération de test de bit.

16. Dispositif informatique selon la revendication 14, dans lequel l'un des noeuds comprend une feuille, la feuille étant associée à des données décodées, et l'unité de traitement est configurée par l'implémentation de l'arbre de codes préfixes binaires pour naviguer jusqu'à la feuille en exécutant un code d'opération de retour en réponse à un résultat de l'exécution du code d'opération de test de bit, lorsqu'il est exécuté, le code d'opération de retour amenant l'unité de traitement à renvoyer les données décodées.

17. Support lisible par ordinateur portant des instructions de traitement pour un dispositif de communication portatif, les instructions de traitement, lorsqu'elles sont exécutées par un processeur d'ordinateur du dispositif de communication portatif, amenant le dispositif de communication portatif à mettre en oeuvre le procédé selon l'une quelconque des revendications 1 à 8.
